Europäisches Patentamt

European Patent Office

Office européen des brevets

(11) Publication number: **0 144 217 B1**

(19)

## EUROPEAN PATENT SPECIFICATION

(45) Date of publication of patent specification: **03.06.92**    (51) Int. Cl.⁵: **H01L 39/22**

(21) Application number: **84308307.2**

(22) Date of filing: **29.11.84**

(54) **Superconducting device.**

(30) Priority: **30.11.83 JP 224311/83**

(43) Date of publication of application:
**12.06.85 Bulletin 85/24**

(45) Publication of the grant of the patent:
**03.06.92 Bulletin 92/23**

(84) Designated Contracting States:
**DE FR GB**

(56) References cited:
**US-A- 4 334 158**

**PATENT ABSTRACTS OF JAPAN, vol. 6, no. 155 (E-125)[1033], 17th August 1982; & JP-A-57 76 890 (KOGYO GIJUTSUIN) 14-05-1982**

(73) Proprietor: **FUJITSU LIMITED**
**1015, Kamikodanaka Nakahara-ku**
**Kawasaki-shi Kanagawa 211(JP)**

(72) Inventor: **Tamura, Hirotaka**
**Tenjin-Haitsu 206 855-4 Tomuro Atsugi-shi**
**Kanagawa 243(JP)**

(74) Representative: **Fane, Christopher Robin King et al**
**HASELTINE LAKE & CO. Hazlitt House 28**
**Southampton Buildings Chancery Lane**
**London, WC2A 1AT(GB)**

EP 0 144 217 B1

## Description

The present invention relates to a superconducting device, more particularly to a superconducting device wherein signal amplification effects and switching operations similar to those of a semiconductor transistor can be obtained.

Typical electronic devices using superconductivity are cryotrons and Josephson tunneling devices. In cryotrons, the superconductive gap $\Delta$ of a thin film can be eliminated by passing a current larger than the critical current through the film, applying an external magnetic field thereto, heating the film or otherwise breaking the superconductive state of the film. Cryotrons, however, suffer from a slow switching speed, e.g. a few $\mu$sec, so have not come into commercial use.

In Josephson tunneling devices, a current of zero volt is passed between two superconductors isolated by an extremely thin tunnel barrier by steps of passing current to the superconductors and applying an external magnetic field thereto. Josephson tunneling devices (below, "Josephson devices") can be operated at a high speed, so studies have been conducted on possible application of the same to switching elements. With Josephson devices, however, the circuit complexity makes it extremely difficult to form circuits with a high signal amplification factor and separated input and output characteristics of semiconductor transistor circuits. Therefore, realization of complex, large-scale circuitry is more difficult with Josephson devices than with semiconductor transistors.

Known superconducting devices realizing signal amplification effects and switching operations similar to those of transistors includes the superconducting transistor of Gray (cf: for example, Gray, Appl. Phys. Lett. vol. 32 No. 6 PP392 to 395) and the Quiteron of Faris (cf: Japanese Unexamined Patent Publication (Kokai) No. 57-12575 corresponding to USP No. 4334158).

The superconducting devices of Gray and Faris are fundamentally similar in structure, i.e. consist of three layers:- a superconducting thin film and two tunnel junctions provided on and below the superconducting thin film. One of the tunnel junctions is used to inject quasiparticles into the superconducting thin film, and the other is used to obtain an output signal.

The devices of Gray and Faris, however, have small amplification factors. For example, published experiments show that the transistor of Gray features a current gain of about 4 and a power gain of about 1 and that a Quiteron features a current gain of about 8 and power gain of about 2. Further, in these experiments, the signal voltage was disadvantageously attenuated in each case.

Further, the Gray transistor and Faris Quiteron feature considerably long switching times, for example, 300 psec in a case of the Quiteron. The switching time depends on the time during which the over-populated state of quasiparticles generated by injection of the quasiparticles is relaxed.

A useful improvement would lie in eliminating the above disadvantages of the prior art and providing a superconducting device having a comparatively large signal amplification factor and high switching speed.

According to the present invention, there is provided a superconductor device including a base region formed of a superconductor material, lying between, and being in contact with, an emitter region, for injecting electrons in the quasiparticle state into the said base region, and a semiconductor portion of a collector region, for capturing electrons in the quasiparticle state from the said base region, the materials of the said base region and the said semiconductor portion of the said collector region being such that when the device is in use, with the said base region in the superconducting state, an energy barrier exists, at a junction between the said base region and the said semiconductor portion of the said collector region, of a height such that electrons in the quasiparticle state can pass freely over that barrier from the said base region to the said semiconductor portion of the collector region whereas passage of Cooper pairs from the base region to the said semiconductor portion of the collector region is substantially completely prevented thereby.

Reference will now be made, by way of example, to the accompanying drawings, wherein:-

Figure 1 is an energy diagram for use in explaining the operational principle of part of a superconductor device embodying the present invention;

Figs. 2A, 2B, 2C and 2D are diagrams for use in explaining the operational principle of superconductor devices embodying the present invention;

Fig. 3 is an energy diagram for use in understanding the structure of a modified superconductor device embodying the present invention;

Fig. 4 shows a cross-sectional view of an embodiment of the present invention; and

Fig. 5 shows a cross-sectional view of another embodiment of the present invention.

Before explaining the preferred embodiments of the present invention the background of the present invention will be explained in more detail.

The Gray's transistor and the Quiteron use a tunnel junction having an insulator as a barrier layer at a portion corresponding to the quasiparticle collector region in a device embodying the present invention. When quasiparticles are emitted to such a tunnel junction, the probability of transmission of the quasiparticles through the barrier due to the tunnel effect is generally small, e.g. approximately $10^{-5}$ to $10^{-10}$. Therefore, to achieve substantially the same level of quasiparticle current flowing in the barrier on the output side as the quasiparticle current injected from an injecting electrode, the number of quasiparticles incident on the tunnel junction per unit time must be $10^5$ to $10^{10}$ times the number of injected quasiparticles per unit time. To increase the number of the quasiparticles incident, the quasiparticle density in the superconductor may be increased. Thus, both Gray's superconducting transistor and the Quiteron have been designed to effectively increase the quasiparticle density in the superconductor as much as possible by the injecting current.

Gray's superconducting transistor uses aluminum, in which the relaxation time of quasiparticles is long. Use is also made of the quasiparticle multiplication effect in which, when high energy quasiparticles are injected, one quasiparticle excites a plurality of quasiparticles, thus increasing the quasiparticle density. In such a case, the amplification factor of the output current against the input current never exceeds the amplification factor of the quasiparticles. Also, the effect on changing the energy gap is very small, so the multiplication factor of the quasiparticles is less than the ratio of the input voltage to the energy gap voltage. Namely, to obtain the current multiplication factor, a voltage two to three times or more of the gap voltage must be biased.

On the other hand, since the voltage to be used as a load is smaller than the gap voltage, the output of Gray's transistor cannot drive other devices.

The Quiteron uses the reduction of the energy gap by the injection of the quasiparticles. Use of the change of the energy gap enables efficient attainment of a large quasiparticle multiplication factor. Thus, the Quiteron features a larger current amplification factor than Gray's transistor.

In this case, as described in Japanese Unexamined Patent Publication (Kokai) No. 57-12575, the quasiparticle energy must be high to efficiently change the energy gap. This means that a high input bias voltage is required, as in Gray's transistor. In turn, the output voltage in the Quiteron is substantially the same as the energy gap voltage, therefore it is also difficult to drive other devices by the Quiteron.

Further, in the Quiteron and Gray's transistor, wherein a tunnel junction is used as a junction for an output, there is the problem that the operating speed is determined by the recombination time of the quasiparticles. The problem derives from the fact that since the effective quasiparticle transmission probability in the tunnel junction is extremely low, the speed of relaxation of the quasiparticle density in the super-conductor becomes substantially the same as the recombination time of the quasiparticles. The substantial recombination time of the quasiparticles is usually a few hundred psec or more.

Superconductor devices embodying the present invention, on the other hand, have a region which we shall call a "quasiparticle collector junction". The capture probability, i.e transmission probability of the quasiparticles, of that junction, is larger as compared to the tunnel junction. In practice, a capture probability of $10^{-3}$ or more is needed. The transmission probability of the quasiparticle collector junction is ideally 1, $10^5$ to $10^7$ times that of a tunnel junction. The quasiparticle collector junction of the present invention does not just have a high quasiparticle transmission probability. If only a high transmission probability were required a tunnel junction having an extremely thin barrier thickness could be used. However, if a bias were applied to such a tunnel junction, not only would the quasiparticles in the superconductor escape outside the tunnel junction, but also a large amount of quasiparticle current would flow into the superconductor. The quasiparticle current exists regardless of the quasiparticle injection from the electrode for injection of the quasiparticles. Further, in a tunnel junction with a high transmission probability, an extremely large quasiparticle current is generated by a small voltage. Thus, in a device which has a thin tunnel barrier as a junction for an output, the output signal cannot be controlled by the input signal.

Another feature of the quasiparticle collector junction in the present invention is that almost no quasiparticle injection from the collector junction into the superconductor is carried out under usual bias conditions. This feature allows the quasiparticle collector junction of the present invention to function substantially the same as the collector junction of a semiconductor bipolar transistor. Quasiparticles injected from a contact portion for quasiparticle injection, hereinafter referred to as a quasiparticle emitter, pass through a superconductor, hereinafter referred to as a base, and the quasiparticle collector and then flow to an outer electrode. This operation is similar to that of a semiconductor bipolar transistor. Since the transmission probability mobility of a quasiparticle collector is high in the superconductor of the present invention, the operating time of the device is not limited by the quasiparticle recombination time. The reason is that almost all the injected quasiparticles reach the quasiparticle collector junction after a very short time to flow out to an outer electrode. Since a quasiparticle travels at a speed of the order of a Fermi velocity, about $10^6$ m/sec, only about 0.1 psec is required to run through a usual base layer having a width of from 100 to 200 nm.

The feature of the present invention resides in that a semiconductor-superconductor contact having a low barrier height or a tunnel junction having a low barrier height is used as a quasiparticle collector junction which captures quasiparticles with a high efficiency.

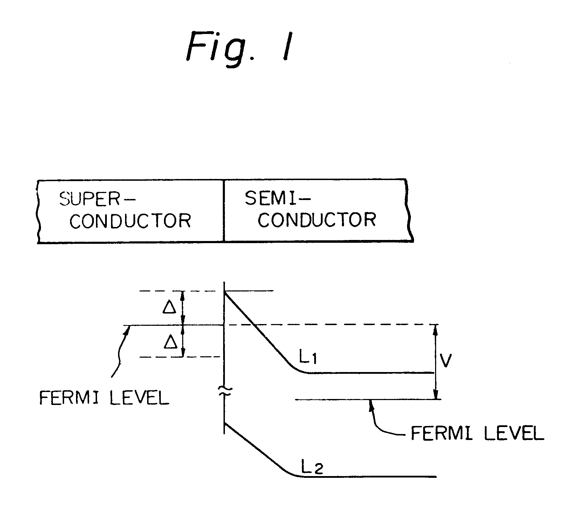

The operational principle of a superconductor device possessing such a quasiparticle collector junction will now be explained with reference to Fig. 1.

As shown in Fig. 1, a region of the device formed of a superconductor material is in contact with another region of the device formed of semiconductor material, and an energy barrier having a height $\psi$ measured from the Fermi level is formed at the junction between the two regions. In this case, an energy gap $\Delta$ is used in place of $\psi$ for simplification.

Now, a positive voltage as compared with the superconductor region is applied to the quasiparticle collector constituted by the semiconductor region.

The process wherein an electron maintained at a quasiparticle state in the superconductor region is transmitted across the quasiparticle collector junction to the semiconductor region will be explained below.

This electron is maintained at an energy level higher than the Fermi level of the superconductor region by E, E being the excited energy of the quasiparticle and larger than the energy $\Delta$. Thus, the electron freely flows over the barrier into the semiconductor region. On the other hand, in the semiconductor region, an electric field directed to a direction which draws the electron from the junction is maintained. Thus, electrons in the quasiparticle state incident on the collector junction are captured and flow out to the semiconductor region.

The process wherein superconducting Cooper pairs in the superconductor region are broken and the obtained electrons, maintained at the quasiparticle state, are transmitted to the semiconductor region will be explained. Electrons transmitted to the semiconductor region are maintained at an energy level lower than the Fermi energy by E. If this level is in the forbidden band or if the height of the barrier is sufficiently greater than the level, such an electron moving process does not occur. Thus, the Cooper pairs, which exist as so-called majority carriers in the superconductor, do not contribute to the current of the quasiparticle collector junction. The quasiparticles that contribute to the current of the quasiparticle collector junction are the quasiparticles injected from a further region, that is the quasiparticle emitter junction, and quasiparticles generated by the excitation by photons in the superconductor, or base, region of the device.

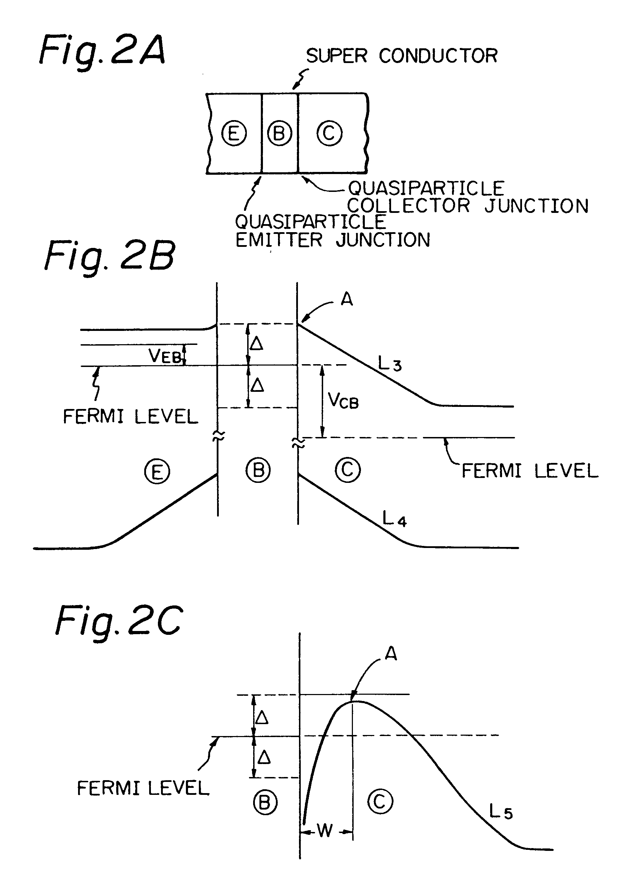

The operational principle of a superconductor device possessing a quasiparticle emitter junction and a quasiparticle collector junction will now be explained with reference to Figs. 2A to 2D.

As shown in Fig. 2A, a thin superconducting base layer B, composed of Nb for example, is sandwiched between a quasiparticle collector junction and a quasiparticle emitter junction. The emitter, shown by E, and the collector, shown by C, are both made of InSb.

As illustrated in Fig. 2B, the quasiparticle emitter E is biased with a negative voltage $V_{EB}$ of about 1.5 to 2 meV at the side of the semiconductor. A collector-base voltage $V_{CB}$ is about 4 meV. Almost all the electrons in the quasiparticle state injected from the quasiparticle emitter E flow into the quasiparticle collector junction, but some recombine to form Cooper pairs and flow out of the base electrode (not shown).

Thus, if the quasiparticle emitter current is expressed as $I_E$, the quasiparticle collector current $I_C$ can be shown by the following expression (1).

$$I_C = I_E + I_{sat}$$

wherein $\alpha$ is a current transfer coefficient. The time for which injected quasiparticles stay in the base region before capture by the quasiparticle collector junction can be determined by the time in which the quasiparticles run in the base region. This time is assumed to be about 0.1 psec, as mentioned above. The staying time in the base region is slightly increased by scattering of the quasiparticles in the base region or by the transmission probability of the quasiparticle collector junction when that factor is less than 1. On the other hand, the recombination time of quasiparticles is at least a few hundred psec to a few nsec: two to three orders larger than the staying time in the base region. Consequently, it is assumed that almost all the quasiparticles flow into the quasiparticle collector C without recombination. Thus, the value $\alpha$ becomes nearly 1.

The above expression (1) means that a superconductor device embodying the present invention functions similarly to a semiconductor bipolar transistor. Since $\alpha$ is nearly 1, a large current amplification factor can be obtained by an emitter-ground circuit system.

As explained above, a superconductor device embodying the present invention does not essentially require a change in the energy gap for operation. Further, the time which quasiparticles stay in the base region is very short, enabling high speed operation. The working voltage is a few millivolts, and the power is considerably small.

The barrier height $\psi$ is shown by the energy

gap $\Delta$ from the Fermi level for simplification in Figs. 1 and 2B, but the actual state of the barrier height is shown in Fig. 2C. Namely, the curve $L_1$ in Fig. 1 and the Curve $L_3$ in Fig. 2B actually correspond to the curve $L_5$ in Fig. 2C. In Fig. 2C, the barrier height is defined as the height from the Fermi level to a portion A, the highest portion in the curve $L_5$. The highest portion A is lower than the energy gap $\Delta$ level. Further, the width W between the quasiparticle collector junction and a vertical line on which the portion A is located has to be smaller than the mean free path in the semiconductor to efficiently capture quasiparticles within the collector region C.

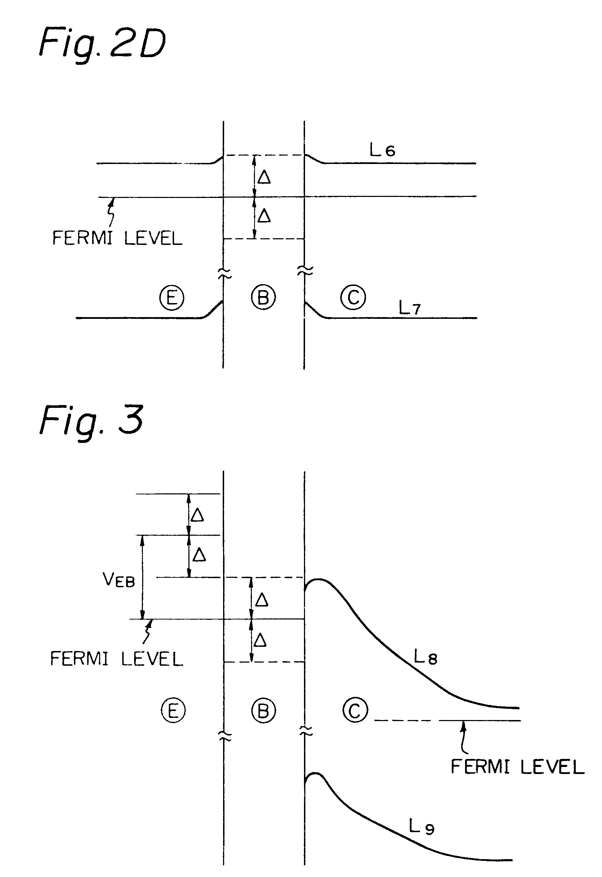

Figure 2D shows an energy diagram for the device in the absence of biases. As shown in Fig. 2D, the energy level in the emitter E is substantially the same as that in the collector C.

Figure 3 is an energy diagram illustrating the structure of a device embodying the present invention, wherein the emitter region E, and base region B, are made of superconductors. In Fig. 3, a base-collector bias $V_E$ is applied.

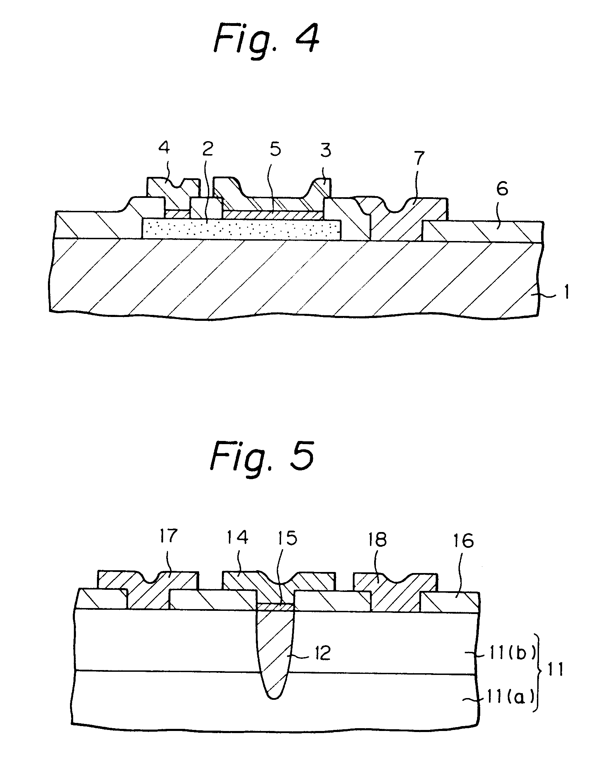

Embodiments of the present invention will now be described with reference to Figs. 4 and 5.

The device of Fig. 4 has, formed on a semiconductor substrate 1 of, for example, GaAs, InP, InA, or InSb, a base region comprising a thin film 2 made of a superconductor material, for example Pb alloy, Nb, or NbN. On the superconductor thin film 2 a tunnel oxide film 5 is formed through a window formed in an insulating layer 6, for example a vapour-deposited SiO film or an $SiO_2$ film deposited by a chemical vapour deposition (CVD) process, a sputtering process, or the like. The tunnel oxide film 5 has formed on it an electrode 3 for injecting quasiparticles and an electrode 4 for base bias. The electrode 3 may be composed of aluminium, molybdenum, or the like, which are normally-conducting metals, and the electrode 4 may be made of a superconductor material, for example Pb alloy or Nb. The electrode 3 and the portion of the tunnel oxide film 5 on which it is provided together constitute an emitter region of the device. The semiconductor substrate 1, on which the superconductor film 2 is formed, constitutes a collector region of the device. The height of the energy barrier formed at a junction between the base and collector regions, i.e. the height of the barrier at the superconductor-semiconductor contact portion, is considerably low.

Between the superconductor of the electrode 4 and the superconductor thin film 2, which operate as a base, a Josephson junction is formed. No electric potential is generated by a usual base current. A collector electrode 7 is connected to the semiconductor substrate 1 by an ohmic contact.

In this embodiment, the thickness of the base region is easily reduced. Thus, a high current transfer function and a small base-ground saturated current $I_{sat}$ can be realised. In turn, since a tunnel junction is present between the base bias electrode and the base region, transfer of the quasiparticles from the base bias electrode to the base region may be decreased, whereby $I_{sat}$ is advantageously lowered. The quasiparticle capture probability is about $10^{-2}$ in the embodiment of Fig. 4.

Figure 5 shows another embodiment of the present invention. As shown in Fig. 5, a superconductor 12 acting as a base region is buried in a small-width groove formed in a semiconductor substrate 11. The semiconductor substrate 11 has a layer 11(a) having insulation characteristics at an operating temperature of about 4.2 K and an active layer 11(b). The groove formed in the semiconductor substrate 11 isolates the emitter and collector portions of the active layer 11(b). A superconductor 14 contacts the superconductor 12 through a tunnel oxide film 15, forming a Josephson junction. The superconductor 14 works as a base electrode in this device. Ohmic electrodes 17 and 18 are provided as an emitter electrode and a collector electrode on the surface of the semiconductor substrate 11. The quasiparticle capture probability is about $10^{-2}$ in the device of Fig. 5.

In the embodiment of Fig. 5, a superconductor-semiconductor contact is used as a quasiparticle emitter. Since the superconductor-semiconductor contact has a small capacitance, the charging and discharging times of the emitter are short, enabling the device to be advantageously operated at a high speed.

In the present invention, the superconductor used as the base region may be composed of superconducting layers including metal layers.

**Claims**

1. A superconductor device comprising a base region (2; 12) formed of a superconductor material, lying between, and being in contact with, an emitter region (3, 5; 11(b), 17), for injecting electrons in the quasiparticle state into the said base region (2; 12), and a semiconductor portion (1; 11(b)) of a collector region (1, 7; 11(b), 18), for capturing electrons in the quasiparticle state from the said base region, the materials of the said base region and the said semiconductor portion of the said collector region being such that when the device is in use, with the said base region in the superconducting state, an energy barrier exists, at a junction between the said base region (2; 12) and the said semiconductor portion of the said collector region (1, 7; 11(b), 18), of a height such that electrons in the quasiparticle state can pass freely over that barrier from the said base region (2; 12) to the said semiconductor portion of the collector region (1, 7; 11(b), 18) whereas passage of Cooper pairs from the base region to the said semiconductor portion of the collector region is substantially completely prevented thereby.

2. A device as claimed in claim 1, wherein a tunnel junction is formed at an interface between the said emitter and base regions (3, 5; 2) through which electrons in the quasiparticle state are injected into said base region.

3. A device as claimed in claim 2, wherein the said emitter region (3, 5) comprises an electrode portion (3) and a tunnel portion (5), which tunnel portion (5) lies between, and in contact with, the said electrode portion (3) and the said base region (2).

4. A device as claimed in claim 1, wherein the said emitter region (11(b), 17) comprises a semiconductor portion (11(b)) which is in contact with the said base region (12).

5. A device as claimed in claim 4, wherein the said emitter region (11(b), 17) further comprises an electrode portion (17) provided on the said semiconductor portion (11(b)).

6. A device as claimed in claim 3 or 5, wherein the said electrode portion (3; 17) is made of non-superconductive conductor material and there is an energy barrier at a junction between the said base (2; 12) and emitter (3, 5; 11(b), 17) regions the height of which, with respect to the Fermi level, is substantially equal to the energy gap of the said superconductor material.

7. A device as claimed in any preceding claim, wherein the said collector region (1, 7; 11(b), 18) comprises an electrode portion (7; 18) provided on the said semiconductor portion (1; 11(b)).

8. A device as claimed in claim 7, wherein the said electrode portion (7; 18) of the collector region is made of non-superconductive conductor material and there is an energy barrier at a junction between the said base (2; 12) and collector (1, 7; 11(b), 18) regions the height of which, with respect to the Fermi level, is substantially equal to the energy gap of the said superconductor material.

**Revendications**

1. Dispositif supraconducteur comprenant une région de base (2 ; 12) formée d'un matériau supraconducteur qui se trouve, en contact avec elles, entre une région d'émetteur (3, 5 ; 11(b), 17), servant à injecter dans ladite région de base (2 ; 12) des électrons se trouvant dans l'état de quasi-particule, et une partie semiconductrice (1; 11(b)) d'une région de collecteur (1, 7 ; 11(b), 18), servant à capturer les électrons se trouvant dans l'état de quasi-particule qui viennent de ladite région de base, les matériaux utilisés pour ladite région de base et ladite partie semiconductrice de ladite région de collecteur étant tels que, lorque le dispositif est en cours d'utilisation, ladite région de base se trouvant alors dans l'état supraconducteur, il existe une barrière d'énergie, présente à la jonction entre ladite région de base (2 ; 12) et ladite partie semiconductrice de ladite région de collecteur (1, 7 ; 11(b), 18), d'une hauteur telle que les électrons se trouvant dans l'état de quasi-particule peuvent passer librement au-dessus de cette barrière, de ladite région de base (2 ; 12) à ladite partie semiconductrice de la région de collecteur (1, 7 ; 11(b), 18), tandis que le passage de paires de Cooper de ladite région de base à ladite partie semiconductrice de la région de collecteur est en pratique complètement empêché.

2. Dispositif selon la revendication 1, où une jonction tunnel est formée à l'interface entre lesdites régions d'émetteur et de base (3, 5 ; 2), par laquelle des électrons se trouvant dans l'état de quasi-particule sont injectés dans ladite région de base.

3. Dispositif selon la revendication 2, où ladite région d'émetteur (3, 5) comprend une partie électrode (3) et une partie tunnel (5), laquelle partie tunnel (5) se trouve, en contact avec elles, entre ladite partie électrode (3) et ladite région de base (2).

4. Dispositif selon la revendication 1, où ladite région d'émetteur (11(b), 17) comprend une partie semiconductrice (11(b)) qui est en contact avec ladite région de base (12).

5. Dispositif selon la revendication 4, où ladite région d'émetteur (11(b), 17) comprend en outre une partie électrode (17) disposée sur ladite partie semiconductrice (11(b)).

6. Dispositif selon la revendication 3 ou 5, où ladite partie électrode (3 ; 17) est faite d'un matériau conducteur non supraconducteur, et où il existe, à la jonction entre lesdites régions de base (2 ; 12) et d'émetteur (3, 5 ; 11(b), 17), une barrière d'énergie dont la hauteur, par rapport au niveau de Fermi, est sensiblement égale à la bande interdite d'énergie dudit matériau supraconducteur.

7. Dispositif selon l'une quelconque des revendications précédentes, où ladite région de collecteur (1, 7 ; 11(b), 18) comprend une partie électrode (7 ; 18) disposée sur ladite partie semiconductrice (1; 11(b)).

8. Dispositif selon la revendication 7, où ladite partie électrode (7 ; 18) de la région de collecteur est faite d'un matériau conducteur non supraconducteur, et où il existe, à la jonction entre lesdites régions de base (2 ; 12) et de collecteur (1, 7 ; 11(b), 18), une barrière d'énergie dont la hauteur, par rapport au niveau de Fermi, est sensiblement égale à la bande interdite d'énergie dudit matériau supraconducteur.

**Patentansprüche**

1. Eine supraleitende Anordnung mit einer Basiszone (2; 12) aus einem supraleitenden Material, welche sich zwischen und in Verbindung mit einer Emitterzone (3, 5; 11(b), 17) für die Injektion von Elektronen im Quasiteilchen-Zustand in die genannte Basiszone (2; 12) und einem Halbleiterteil (1; 11(b)) einer Kollektorzone (1, 7; 11(b), 18) für das Einfangen von Elektronen im Quasiteilchen-Zustand von der genannten Basiszone, wobei die Materialien der genannten Basiszone und des genannten Halbleiterteils der genannten Kollektorzone so beschaffen sind, daß, wenn die Anordnung in Gebrauch und die genannte Basiszone im supraleitenden Zustand ist, an einem Übergang zwischen der genannten Basiszone (2; 12) und dem genannten Halbleiterteil der genannten Kollektorzone (1, 7; 11(b), 18) eine Energieschwelle mit einer solchen Höhe vorhanden ist, daß Elektronen im Quasiteilchen-Zustand über diese Schwelle von der genannten Basiszone (2; 12) zum genannten Halbleiterteil der Kollektorzone (1, 7, 11(b), 18) frei passieren können, wogegen die Passage von Cooper-Paaren von der Basiszone zum genannten Halbleiterteil der Kollektorzone durch sie im wesentlichen vollkommen verhindert wird.

2. Eine Anordnung nach Anspruch 1, in welcher an einer Schnittstelle zwischen der genannten Emitter- und Basiszone (3, 5; 2) ein Tunnelübergang gebildet ist, durch den Elektronen im Quasiteilchen-Zustand in die genannte Basiszone injiziert werden.

3. Eine Anordnung nach Anspruch 2, in welcher die genannte Emitterzone (3, 5) einen Elektrodenteil (3) und einen Tunnelteil (5) umfaßt, wobei sich der Tunnelteil (5) zwischen und in Verbindung mit dem genannten Elektrodenteil (3) und der genannten Basiszone (2) befindet.

4. Eine Anordnung nach Anspruch 1, in welcher die genannte Emitterzone (11(b), 17) einen Halbleiterteil (11(b)) umfaßt, welcher sich in Verbindung mit der genannten Basiszone (12) befindet.

5. Eine Anordnung nach Anspruch 4, in welcher die genannte Emitterzone (11(b), 17) ferner einen Elektrodenteil (17) beinhaltet, der sich auf dem genannten Halbleiterteil (11(b)) befindet.

6. Eine Anordnung nach Anspruch 3 oder 5, in welcher der genannte Elektrodenteil (3; 17) aus nicht-supraleitendem Leitermaterial besteht und an einem Übergang zwischen der genannten Basis- (2; 12) und Emitterzone (3, 5; 11(b), 17) eine Energieschwelle vorhanden ist, deren Höhe in bezug auf das Fermi-Niveau im wesentlichen gleich der Energielücke des genannten supraleitenden Materials ist.

7. Eine Anordnung nach irgendeinem vorhergehenden Anspruch, in welcher die genannte Kollektorzone (1, 7; 11(b), 18) einen Elektrodenteil (7; 18) beinhaltet, der sich auf dem genannten Halbleiterteil (1; 11(b)) befindet.

8. Eine Anordnung nach Anspruch 7, in welcher der genannte Elektrodenteil (7; 18) der Kollektorzone aus einem nichtsupraleitendem Leitermaterial besteht und sich eine Energieschwelle an einem Übergang zwischen der genannten Basis-(2; 12) und Kollektorzone (1, 7; 11(b), 18) befindet, deren Höhe in bezug auf das Fermi-Niveau im wesentlichen gleich der Energielücke des genannten supraleitendem Materials ist.

# *Fig. I*

| SUPER-<br>CONDUCTOR | SEMI-<br>CONDUCTOR |
|---|---|

FERMI LEVEL

$\Delta$

$\Delta$

$L_1$

$V$

FERMI LEVEL

$L_2$

## Fig. 2A

SUPER CONDUCTOR

(E) (B) (C)

QUASIPARTICLE
COLLECTOR JUNCTION

QUASIPARTICLE
EMITTER JUNCTION

## Fig. 2B

A

$\Delta$

$V_{EB}$

$\Delta$

$L_3$

$V_{CB}$

FERMI LEVEL

FERMI LEVEL

(E) (B) (C)

$L_4$

## Fig. 2C

A

$\Delta$

$\Delta$

FERMI LEVEL

(B) (C)

$L_5$

W

## Fig. 2D

$\Delta$

$\Delta$

$L_6$

FERMI LEVEL

Ⓔ  Ⓑ  Ⓒ  $L_7$

## Fig. 3

$\Delta$

$\Delta$

$V_{EB}$

$\Delta$

$\Delta$

FERMI LEVEL

Ⓔ  Ⓑ  Ⓒ  $L_8$

FERMI LEVEL

$L_9$

*Fig. 4*

4    2    5    3    7    6

1

*Fig. 5*

17    14    15    18    16

12    11(b)    11
11(a)